Europäisches Patentamt

European Patent Office

Office européen des brevets

(11) Veröffentlichungsnummer: **0 215 462
B1**

# EUROPÄISCHE PATENTSCHRIFT

(45) Veröffentlichungstag der Patentschrift:
22.08.90

(51) Int. Cl.⁵: **C03C 8/24,** C04B 37/00,
H01L 23/48

(21) Anmeldenummer: 86112697.7

(22) Anmeldetag: 13.09.86

(54) Paste zum Verbinden von Halbleitern mit keramischen Unterlagen.

(30) Priorität: 16.09.85 US 776610

(43) Veröffentlichungstag der Anmeldung:
25.03.87 Patentblatt 87/13

(45) Bekanntmachung des Hinweises auf die Patenterteilung:
22.08.90 Patentblatt 90/34

(84) Benannte Vertragsstaaten:
DE FR GB NL

(56) Entgegenhaltungen:
GB-A- 2 103 250
US-A- 4 251 595

(73) Patentinhaber: DEMETRON Gesellschaft für
Elektronik-Werkstoffe m.b.H., Leipziger Strasse 10,
D-6450 Hanau 1(DE)
Patentinhaber: Degussa Aktiengesellschaft,
Weissfrauenstrasse 9, D-6000 Frankfurt am Main 1(DE)

(72) Erfinder: Dumesnill, Maurice E., 27850 Via Feliz, Los
Altos, Hills, CA 94022(US)
Erfinder: Starz, Karl, Dr., Bergstrasse 10B,
D-6450 Rodenbach(DE)
Erfinder: Finkelshteyn, Leonid, 1643 27th Avenue, San
Francisco, CA 94122(US)

**Beschreibung**

Die Erfindung betrifft eine Paste zum Verbinden von Halbleitern, insbesondere aus Silizium, mit keramischen Unterlagen, bestehend aus 75 bis 85 Gew. % eines Gemisches aus Silberpulver und einem niedrigschmelzenden Glaspulver, wobei das Gewichtsverhältnis Silber zu Glas zwischen 2 : 1 und 9 : 1 liegt, und 15 bis 25 Gew. % eines organischen Lösungsmittels, das 1 bis 10 Gew. % eines unterhalb des Glaserweichungspunktes thermisch zerfallenden Harzes enthält.

Halbleiter, insbesondere Siliziumhalbleiter, werden in vielen Fällen mit keramischen Unterlagen verbunden, die auch metallisiert sein können. Dazu verwendet man neuerdings Pasten, die aus feinverteilten Silber- und Glaspulver bestehen, vermischt mit einem Lösungsmittel und einem thermisch zersetzbaren Harz. Diese Pasten werden auf die keramischen Unterlagen in dünner Schicht aufgebracht, der Halbleiter aufgelegt und dieses Gebilde dann auf Temperatur oberhalb 400° C erhitzt, wobei Lösungsmittel und Harz entweichen, das Glas erweicht und zusammen mit dem Silberpulver eine festhaftende Verbindung zwischen keramischer Unterlage und Halbleiter herstellt.

Aus der DE-A 32 27 815 ist eine Metallisierungspaste zum Aufkleben von Siliziumhalbleitern auf keramischen Unterlagen bekannt, bestehend aus 75 bis 85 Gew. % eines Gemisches aus 20 bis 95 Gew. % feinverteiltem Silber und 5 bis 80 Gew.% eines niedrigschmelzenden Glaspulvers und 15 bis 25 Gew.% eines organischen Lösungsmittels. Das verwendete Glas besteht im wesentlichen aus 95 bis 96 Gew.% Bleioxid, 0,25 bis 2,5 Gew.% Siliziumoxid, Rest Boroxid. Dieses Glas besitzt einen Erweichungspunkt von 325° bis 425°. Das Verbinden von Siliziumscheibe und keramischer Unterlage erfolgt bei Brenntemperaturen zwischen 425 und 525°C, insbesondere bei 430°C.

Entscheidend für dieses Verbindungsverfahren ist eine gute Haftfestigkeit des Halbleiters auf der Unterlage und das Vermeiden der Entstehung von thermischen Spannungen innerhalb des Halbleiters und zwischen Halbleiter und keramischer Unterlage. Diese Spannungen sind umso geringer, je tiefer die Brenntemperatur gehalten werden kann. Sie treten besonders dann auf, wenn die Halbleiterscheibe groß und die keramische Unterlage vergoldet ist. Diese Goldschichten sind normalerweise auf Nickelzwischenschichten aufgebracht und bei 430°C und höher sollten daher möglichst vermieden werden.

Aus der US-A 4 251 595 sind Gläser bekannt, die Erweichungstemperaturen zwischen 260 und 280°C aufweisen und 75 bis 85 Gew.% Bleioxid, 8 bis 15 Gew. % Boroxid, 0,5 bis 2,5 Gew.% Siliziumdioxid, 0 bis 10 Gew.% Zinkoxid, 0 bis 5 Gew.% Wismutoxid, 0,5 bis 5,5 Gew.% Kupferoxid, 0,1 bis 3 Gew.% Aluminiumoxid und ein Metallfluorid enthalten. Diese Gläser werden für Pasten verwendet, die außerdem noch Bleititanatpulver und einen organischen Träger enthalten. Sie dienen zum hermetischen Versiegeln von keramischen Gehäusen für Halbleiter. Über ihre Eignung zum Benetzen von Halbleitermaterialien und zur Ausbildung sehr haftfester Bindung an diesen Materialien wird in dieser Schrift aber nichts gesagt.

Es war Aufgabe der vorliegenden Erfindung, eine Paste zum Verbinden von Halbleitern, insbesondere aus Silizium, mit keramischen Unterlagen zu entwickeln, bestehend aus 75 bis 85 Gew.% eines Gemisches aus Silberpulver und einem niedrigschmelzenden Glaspulver, wobei das Gewichtsverhältnis Silber zu Glas zwischen 2 : 1 und 9 : 1 liegt, und 15 bis 25 Gew.% eines organischen Lösungsmittels, das 1 bis 10 Gew.% eines unterhalb des Glaserweichungspunktes thermisch zerfallenden Harzes enthält, die bei möglichst niedrigen Brenntemperaturen eine optimale Haftfestigkeit zwischen Halbleiter und keramischer Unterlage liefert.

Diese Aufgabe wird erfindungsgemäß dadurch gelöst, daß das Glaspulver aus 75 bis 85 Gew. % Bleioxid, 8 bis 15 Gew. % Boroxid, 0,75 bis 2,5 Gew. % Siliziumoxid, 0 bis 10 Gew. % Zinkoxid, 0 bis 5 Gew. % Wismutoxid, 0 bis 3 Gew. % Aluminiumoxid, 0,5 bis 5,5 Gew. % Kupferoxid und einem nichtflüchtigen Metallfluorid als Rest besteht, wobei die Menge des Metallfluorids so gewählt werden muß, daß das Molverhältnis von Kupferoxid ($Cu_2O$) zum Fluoridgehalt des Metallfluorids zwischen 1 : 0,25 und 1 : 10 liegt, und eine Erweichungstemperatur zwischen 260 und 280° C aufweist.

Vorzugsweise besteht das Glaspulver aus 75 bis 85 Gew.% Bleioxid, 8 bis 15 Gew. % Boroxid, 0,75 bis 2,5 Gew. % Siliziumoxid, 1 - 5 Gew. % Wismutoxid, 0,5 bis 5,5 Gew.% Kupferoxid, 0 bis 8 Gew. % Zinkoxid, 0 bis 3 Gew. % Aluminiumoxid, Rest Bleifluorid, Kupferfluorid und/oder Zinkfluorid, wobei das Molverhältnis Kupferoxid zu Fluoridgehalt des Metallfluorids zwischen 1 : 0,25 und 1 : 10 liegen muß.

Das Silberpulver kann in Form von kugeligen oder plättchenförmigen Teilchen oder Gemischen davon vorliegen. Das Pulver besitzt vorteilhafterweise eine Oberfläche von 0,3 bis 1,3 m$^2$/g und eine Klopfdichte zwischen 2,4 und 3,4 g/cm$^3$. Als Glaskomponente haben sich Gläser folgender Zusammensetzung bewährt:

a) 77.9% PbO, 7,2 % ZnO, 8,2 % $B_2O_3$, 0,9 % $SiO_2$, 2,2 % $Cu_2O$, 0.4% Fluorid als $PbF_2$, 3,2 % $Bi_2O_3$;
b) 79,2 % PbO, 5,5 % ZnO, 9,2 % $B_2O_3$, 0,9 % $SiO_2$, 1,4 % $Cu_2O$, 0,8 % F als $PbF_2$, 3,0 % $Bi_2O_3$;
c) 80,8 % PbO, 6,8 % ZnO, 8,7 % $B_2O_3$, 1,0 % $SiO_2$, 2,3 % $Cu_2O$, 0.4% F als $PbF_2$;
d) 81,6 % PbO, 3,1 % ZnO, 11,5 % $B_2O_3$, 1,0 % $SiO_7$, 2,1 % $Cu_2O$, 0,7 % F als $PbF_2$.

Das Gewichtsverhältnis von Silber zu Glas liegt im Bereich zwischen 2 : 1 und 9 : 1, vorzugsweise zwischen 3 : 1 und 5 : 1. Besonders bewährt hat sich ein Silber zu Glasgewichtsverhältnis von 4 : 1. Die verwendeten Gläser zeigen bei Temperaturen von 430° C während einer Erhitzungsdauer von 15 Minuten keine Entglasungserscheinungen.

Zum Auftragen der Silber-Glas-Paste auf die keramische Unterlage, wird ein Gemisch aus Silberpulver und Glaspulver in einem organischen Lösungsmittel mit einem Siedepunkt unterhalb 265° C aufgeschlämmt. Als organische Lösungsmittel können beispielsweise Terpineol, Diäthylenglykoläther (Carbitole) bzw. deren Ester, oder Esteralkohole wie 2,2, 4-Trimethyl-pentandiol-1,3-monoisobutyrat Verwendung finden. Auch andere organische Lösungsmittel mit Siedepunkten zwischen 100° und 265° C können eingesetzt werden.

Ein Harz, das sich unterhalb des Erweichungspunktes des verwendeten Glases thermisch zersetzt, d.h. unterhalb 280° C, wird im organischen Lösungsmittel aufgelöst, normalerweise in Mengen von 1 bis 10 Gew. %. Verwendet werden beispielsweise Nitrocellulose in Mengen von 1 bis 2 % oder Äthyl- oder Butylmethacrylat in Mengen von 6 bis 10 %. Das Harz erhöht die Viskosität des organischen Trägers und verhindert so das Absetzen der Pulver in der Paste.

Eine kleine Menge der Paste wird beispielsweise mittels einer Spritze auf die keramische Unterlage in Form eines kleinen Kegels aufgebracht und der Halbleiter aufgedrückt.

Dieses Gebilde wird dann sorgfältig bei 75 bis 150° C solange getrocknet, bis das Lösungsmittel vollständig ausgetrieben ist. Dann wird auf Temperaturen unterhalb 400° C erhitzt, vorzugsweise auf 380° C, wobei sich das Harz zersetzt und eine feste Verbindung zwischen keramischer Unterlage und Halbleiter entsteht.

Anstatt des kegelförmigen Pastenauftrags kann die keramische Unterlage auch mit einer Pastenschicht versehen werden, auf die der Halbleiter aufgelegt wird.

Folgendes Beispiel soll die Erfindung näher erläutern:

415 g Bleioxid, 30 g Bleifluorid, 30 g Zinkoxid, 80 g Borsäure, 5 g Siliziumoxid, 12 g Kupferoxid, 8 g Wismutoxid und 10 g Aluminiumhydroxid wurden gemischt und 30 Minuten bei 1100° C in einer Platinschale geschmolzen. Die Schmelze wurde anschließend über Stahlwalzen abgegossen und die entstandenen Glasplättchen in Keramikkugelmühlen zu einem feinen Pulver verarbeitet. 20g dieses Glaspulvers wurden mit 80 g Silberpulver vermischt (Klopfdichte 3 g/cm³, Oberfläche 1 m²/g.)30 g Butylcarbitol, in dem 0,3 g Nitrocellulose (Molekulargewicht rund 2000) gelöst waren, wurde dem Silber-Glas-Pulvergemisch zugefügt und dieses zu einer Paste verarbeitet.

Eine analoge Paste gemäß dem Stand der Technik wurde aus 66,4 % Silber, 16,6 % Glas (Zusammensetzung gemäß DE-OS 32 27 815), 1 % Nitrocellulose und 16 % Butylcarbitol hergestellt. Sie entspricht in ihrer Zusammensetzung bis auf die Glaskomponente in etwa der erfindungsgemäßen Paste.

Beide Pasten wurden verwendet, um gleichgroße Halbleiter, die mit unterschiedlichen Rückseiten-Beschichtungen versehen waren, auf keramische Unterlagen aufzubringen.

Die keramische Unterlage bestand aus Aluminiumoxid (etwa 92%) mit kleinen Anteilen (je etwa 2 %) an Siliziumoxid, Titandioxid, Eisenoxid und Manganoxid. Das Verbinden erfolgte bei Brenntemperaturen von jeweils 380° C und 430° C. Die Haftfestigkeit wurde mit einem Ziehtest bestimmt. Die Ergebnisse sind in der folgenden Tabelle festgehalten:

### Tabelle

| Beschichtung der Halbleiter-Rückseite mit | Haftfestigkeit [kpsi] | | | |
| | Erfindungsgemäße Paste | | Paste gemäß DE-A 3 227 815 | |
| | 380°C | 430°C | 380°C | 430°C |
| SiO₂ | 2,8 | 3,0 | 1,8 | 2,9 |
| Cr/Au (aufgedampft) | 2,8 | 2,9 | 0,4 | 0,8 |
| Cr/Au (gesputtert) | 2,9 | 3,1 | 1,0 | 1,5 |
| Al₂O₃ | 3,5 | 3,5 | 1,9 | 3,5 |

Die Dicke der Verbindungsschicht aus Silber-Glas betrug in allen Fällen 50 bis 70 µm (2 - 2,5 mils).

Aus den Haftfestigkeitswerten ersieht man, daß die Haftfestigkeit bei Brenntemperaturen von 380° C mit der erfindungsgemäßen Paste gleich groß oder größer ist als die Haftfestigkeit mit der Paste gemäß DE-A 32 27 815 bei Brenntemperaturen von 430° C.

Außerdem unterscheiden sich die Haftfestigkeiten mit der erfindungsgemäßen Paste bei den Brenntemperaturen von 380° C und 430° C nur wenig. Thermische Spannungen zwischen dem Halbleiter und der Unterlage traten bei Brenntemperaturen von 380° C in keinem Fall auf, im Gegensatz zu Brenntemperaturen von 430° C.

**Patentansprüche**

1. Paste zum Verbinden von Halbleitern, insbesondere aus Silizium, mit keramischen Unterlagen, bestehend aus 75 bis 85 Gew. % eines Gemisches aus Silberpulver und einem niedrigschmelzenden Glaspulver, wobei das Gewichtsverhältnis Silber zu Glas zwischen 2 : 1 und 9 : 1 liegt, und 15 bis 25 Gew. % eines organischen Lösungsmittels, das 1 bis 10 Gew. % eines unterhalb des Glaserweichungspunktes thermisch zerfallenden Harzes enthält,
dadurch gekennzeichnet,
daß das Glaspulver aus 75 bis 85 Gew. % Bleioxid, 8 bis 15 Gew. % Boroxid, 0,75 bis 2,5 Gew. % Siliziumoxid, 0 bis 10 Gew. % Zinkoxid, 0 bis 5 Gew.% Wismutoxid, 0 bis 3 Gew. % Aluminiumoxid, 0,5 bis 5,5 Gew. % Kupferoxid und einem nichtflüchtigen Metallfluorid als Rest besteht, wobei die Menge des Metallfluorids so gewählt werden muß, daß das Molverhältnis von Kupferoxid (Cu$_2$O) zum Fluoridgehalt des Metallfluorids zwischen 1 : 0,25 und 1 : 10 liegt, und eine Erweichungstemperatur zwischen 260°C und 280°C aufweist.

2. Paste nach Anspruch 1,
dadurch gekennzeichnet,
daß das Glaspulver aus 75 bis 85 Gew. % Bleioxid, 8 bis 15 Gew. % Boroxid, 0,75 bis 2,5 Gew. % Siliziumoxid, 1 bis 5 Gew. % Wismutoxid, 0,5 bis 5,5 Gew. % Kupferoxid, 0 bis 8 Gew. % Zinkoxid, 0 bis 3 Gew. % Aluminiumoxid, Rest Bleifluorid, Kupferfluorid und/oder Zinkfluorid besteht, wobei das Molverhältnis Kupferoxid zu Fluoridgehalt des Metallfluorids zwischen 1 : 0,25 und 1 : 10 liegen muß.

**Claims**

1. A paste for fixing semiconductors, more particularly of silicon, to ceramic supports, consisting of 75 to 85% by weight of a mixture of silver powder and a low-melting glass powder, the ratio by weight of silver to glass being from 2 : 1 to 9 : 1, and 15 to 25% by weight of an organic solvent containing 1 to 10% by weight of a resin thermally decomposing below the softening point of the glass, characterized in that the glass powder consists of 75 to 85% by weight lead oxide, 8 to 15% by weight boron oxide, 0.75 to 2.5% by weight silicon oxide, 0 to 10% by weight zinc oxide, 0 to 5% by weight bismuth oxide, 0 to 3% by weight aluminium oxide, 0.5 to 5.5% by weight copper oxide and, for the rest, of a non-volatile metal fluoride, the quantity of the metal fluoride having to be selected so that the molar ratio of copper oxide (Cu$_2$O) to the fluoride content of the metal fluoride is from 1 : 0.25 to 1 : 10, and has a softening temperature between 260 and 280°C.

2. A paste as claimed in claim 1, characterized in that the glass powder consists of 75 to 85% by weight lead oxide, 8 to 15% by weight boron oxide, 0.75 to 2.5% by weight silicon oxide, 1 to 5% by weight bismuth oxide, 0.5 to 5.5% by weight copper oxide, 0 to 8% by weight zinc oxide, 0 to 3% by weight aluminium oxide and, for the rest, of lead fluoride, copper fluoride and/or zinc fluoride, the molar ratio of copper oxide to the fluoride content of the metal fluoride being from 1 : 0.25 to 1 : 10.

**Revendications**

1. Pâte pour assembler des semiconducteurs, en particulier à base de silicium, avec des supports céramiques qui se compose de 75 à 85 % en poids d'un mélange à base de poudre d'argent et d'une poudre de verre à bas point de fusion, pour laquelle le rapport pondéral argent/verre se situe entre 2 : 1 et 9 : 1, et 15 à 25 % en poids d'un solvant organique qui contient 1 à 10 % en poids d'une résine qui se décompose thermiquement en-dessous du point de ramollissement du verre, caractérisée en ce que la poudre de verre se compose de 75 à 85 % en poids d'oxyde de plomb, 8 à 15 % en poids d'oxyde de bore, 0, 75 à 2, 5 % en poids d'oxyde de silicium, 0 à 10 % en poids d'oxyde de zinc, 0 à 5 % en poids d'oxyde de bismuth, 0 à 3 % en poids d'oxyde d'aluminium, 0, 5 à 5, 5 % en poids d'oxyde de cuivre et d'un fluorure métallique non volatil comme restant, dans laquelle la quantité de fluorure métallique doit être choisie, de sorte que le rapport molaire de l'oxyde de cuivre (Cu$_2$O) à la teneur en fluorure, du fluorure métallique, se situe entre 1 : 0,25 et 1 : 10 et manifeste une température de ramollissement comprise entre 260°C et 280°C.

2. Pâte selon la revendication 1, caractérisée en ce que la poudre de verre se compose de 75 à 85% en poids d'oxyde de plomb, 8 à 15% de bore, 0,75 à 2, 5% en poids d'oxyde de silicium, 1 à 5% en poids d'oxyde de bismuth, 0,5 à 5,5% en poids d'oxyde de cuivre, 0 à 8% en poids d'oxyde de zinc, 0 à 3% en poids d'oxyde d'aluminium et le restant est du fluorure de plomb, du fluorure de cuivre et/ou du fluorure de zinc, pour laquelle le rapport molaire oxyde de cuivre à teneur en fluorure métallique doit se situer entre 1 : 0, 25 et 1 : 10.